**Europäisches Patentamt**

**European Patent Office**

**Office européen des brevets**

(11) Numéro de publication : **0 065 535**
**B1**

(12) # FASCICULE DE BREVET EUROPÉEN

(45) Date de publication du fascicule du brevet :
**05.03.86**

(51) Int. Cl.⁴ : **G 08 B 13/18, H 05 K 5/00**

(21) Numéro de dépôt : **81903122.0**

(22) Date de dépôt : **19.11.81**

(86) Numéro de dépôt international :
**PCT/CH 81/00129**

(87) Numéro de publication internationale :
**WO/8201953 (10.06.82 Gazette 82/15)**

(54) **APPAREIL DE SURVEILLANCE.**

(30) Priorité : **27.11.80 CH 8800/80**

(43) Date de publication de la demande :
**01.12.82 Bulletin 82/48**

(45) Mention de la délivrance du brevet :
**05.03.86 Bulletin 86/10**

(84) Etats contractants désignés :
**AT DE FR GB LU NL SE**

(56) Documents cités :
**DE-A- 2 848 533**
**FR-A- 1 348 392**
**GB-A- 1 125 744**
**GB-A- 2 064 879**
**US-A- 3 266 029**
**US-A- 4 092 641**

(73) Titulaire : **3S S.A. GENEVE**
**29 Rue de Neuchâtel**
**CH-1201 Genève (CH)**

(72) Inventeur : **LECHNER, Heinz**
**9, Chemin de Broye**
**CH-1020 Renens (CH)**
Inventeur : **TAILLENS, Jean-François**
**8, Chemin de Butte**
**CH-1049 Sullens (CH)**

(74) Mandataire : **Ardin, Pierre et al**
**PIERRE ARDIN & CIE 22, rue du Mont-Blanc**
**CH-1211 Genève 1 (CH)**

Jouve, 18, rue St-Denis, 75001 Paris, France

## Description

On connaît déjà de nombreuses installations de surveillance qui peuvent être montées dans des locaux commerciaux ou privés (voir par exemple les brevets USA N° 3.266.029 et 4.092.641). Toutefois, le coût de ces installations est élevé, car elles nécessitent la pose de nombreux câbles électriques, de contacteurs de porte ou de fenêtre, etc.

On connaît également des appareils portatifs comprenant un détecteur à ultrasons ou à rayons infrarouges (voir par exemple brevet français N° 1.348.392). Ces derniers appareils ne constituent pas un dispositif de surveillance valable, car la personne qui en dérange le fonctionnement peut facilement les mettre hors service ou même les briser.

La présente invention a pour but de permettre une surveillance d'un local offrant une sécurité élevée et dont le prix de fabrication et d'installation peut être maintenu beaucoup plus bas que celui des installations précitées.

L'invention a pour objet un appareil de surveillance contre le vol, comprenant des moyens de détection et d'alarme réagissant à une présence anormale, ces moyens étant disposés à l'intérieur d'un boîtier comprenant une plaque support amovible munie de moyens pour permettre sa fixation à une partie d'un bâtiment, caractérisé en ce que la plaque support est munie de bornes électriques pour raccorder l'appareil au réseau d'alimentation, ces bornes étant reliées à une partie d'un connecteur fixée à la plaque support, l'autre partie du connecteur étant reliée par des fils souples à des circuits faisant partie desdits moyens de détection et d'alarme, ces moyens étant fixés dans le boîtier, de façon à pouvoir être enlevés avec ce dernier après séparation des deux parties du connecteur.

Le dessin annexé représente schématiquement et à titre d'exemple, une forme d'exécution de l'appareil faisant l'objet de l'invention.

La figure 1 est une vue de face de cet appareil.

La figure 2 est une vue de la face arrière de l'appareil, cette face étant découverte.

La figure 3 montre un couvercle de fermeture de l'appareil.

La figure 4 est un diagramme de fonctionnement.

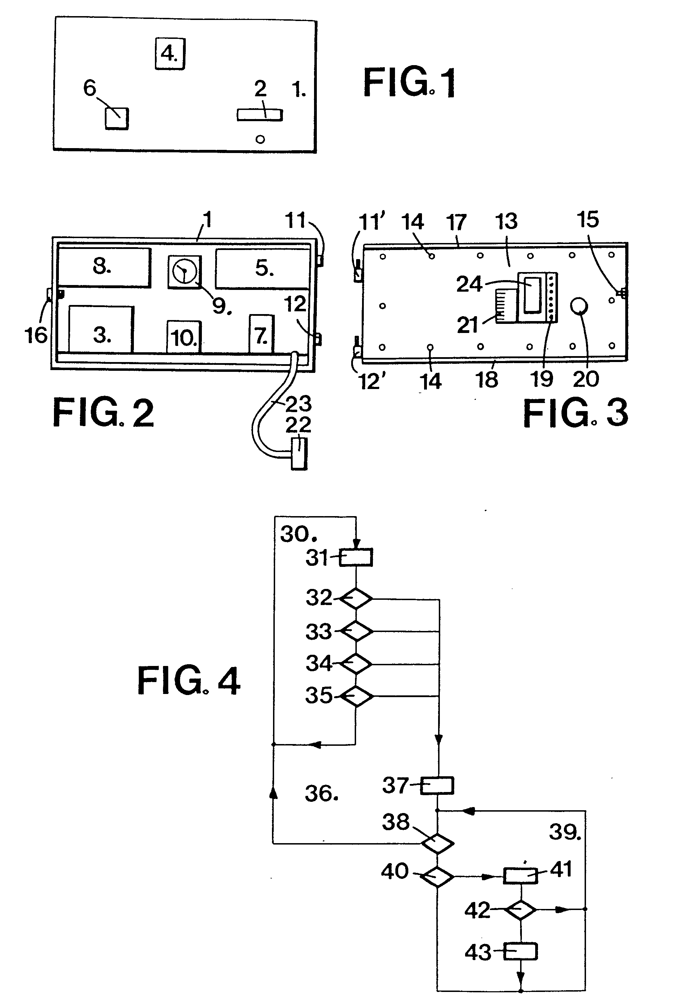

La fig. 1 montre la face avant d'un coffret 1 contenant tous les dispositifs nécessaires à la surveillance. Cette face avant présente une fenêtre 2 pour un capteur 3 de rayonnement infrarouge, une fenêtre 4 permettant d'effectuer une prise de vue par une caméra 5 photographique logée dans le coffret et une fenêtre 6 disposée en face d'un flash électronique 7.

Comme représenté schématiquement à la fig. 2, le coffret 1 contient encore une sirène d'alarme 8, un dispositif d'horlogerie 9 à cycle hebdomadaire, qui est destiné à enclencher automatiquement l'appareil pour les périodes désirées de surveillance, et une batterie de secours 10 permettant l'alimentation de l'appareil en cas de défaillance du réseau d'alimentation.

Le coffret 1 est en tôle d'acier relativement épaisse de façon à être résistant, ce coffret pouvant bien entendu être recouvert de toute matière, notamment de bois, de façon à lui donner un aspect plus esthétique.

Sur l'un de ses bords, le coffret 1 est muni de deux gonds 11 et 12 destinés à s'engager sur des gonds correspondants 11' et 12' d'un couvercle 13, également en tôle d'acier. Ce couvercle présente plusieurs trous 14 permettant de le fixer solidement à une partie d'un bâtiment, notamment à une paroi, au moyen de vis. Ce couvercle 13 porte encore une partie 15 d'une serrure destinée à coopérer avec une autre partie 16 de serrure fixée au coffret 1 et permettant le verrouillage en positon fermée du coffret 1 sur le couvercle 13. En position fermée de l'appareil, il n'est plus possible de dégager les gonds 11 et 12, car le couvercle 13 présente deux ailettes s'engageant pratiquement sans jeu à l'intérieur de l'ouverture du coffret 1.

Le coffret porte encore une série de bornes électriques 19 destinées à relier l'appareil à des câbles extérieurs passant par un trou 20 de ce coffret. Ces câbles sont prévus notamment pour l'alimentation de l'appareil par le réseau. Toutefois, il est possible de prévoir des câbles supplémentaires, par exemple pour relier l'appareil à une installation d'alarme extérieure, à une alarme automatique par téléphone, à un interrupteur commandant l'éclairage du local surveillé, etc. Ces bornes 19 sont reliées à une partie 21 d'un contacteur dont l'autre partie 22 est reliée à l'appareil par des câbles souples 23. Le couvercle porte encore un contacteur à relais 24 fixé au couvercle 13 et dont les contacts électriques sont reliés à certaines des bornes 19. De cette façon, il est possible de réaliser une séparation galvanique des circuits à basse tension contenus dans le coffret 1 et des circuits à courant fort susceptibles d'être commandés par le relais 24.

La disposition décrite est très avantageuse, car la pose de l'appareil ne nécessite pas de travaux importants demandant une main-d'œuvre spécialisée. Le couvercle 13 peut être fixé à une paroi par toute personne sans formation spéciale et les connexions des fils aux bornes 19 peuvent être réalisées rapidement lors de la mise en marche de l'appareil. Il suffit alors de suspendre le coffret 1 aux gonds du couvercle, de brancher le connecteur et de refermer le coffret 1 sur le couvercle 13.

Le détecteur réagissant à une présence anormale ne doit pas nécessairement être du type à fonctionnement à rayonnement infrarouge. Il pourrait être remplacé ou complété par un détecteur à ultrasons ou encore par un radar. De plus, l'appareil pourrait encore comprendre un récepteur sensible à un rayonnement et destiné à mettre l'appareil hors surveillance pendant un temps prédéterminé après réception d'un rayonnement approprié. Cette dernière disposition est avantageuse notamment lorsque les locaux surveillés doivent être parcourus par des personnes effectuant des rondes de nuit. On peut également prévoir un récepteur à rayonnement et un accessoire extérieur pour l'émission d'un rayonnement, par exemple infrarouge, codé destiné à agir sur ledit récepteur pour transmettre des informations relatives à la mise en et hors circuit du dispositif de surveillance.

Dans une variante d'exécution, une grande partie des circuits pourraient être remplacés par un micro-processeur. Le diagramme de fonctionnement de ce micro-processeur est indiqué à la fig. 4. Ce schéma comprend une première boucle 30 selon laquelle on vérifie successivement, à partir d'un état de veille 31, si en 32 l'installation est mise en circuit par une clé ou un interrupteur, en 33 par un code à rayonnement, en 34 par une transmission d'ordres provenant du réseau par l'intermédiaire d'un courant porteur et en 35 par une horloge. Si l'on obtient une réponse affirmative à l'un des critères 32 à 35, le signal passe ensuite dans une boucle 36 comprenant un dispositif 37 donnant un faible signal acoustique pendant une durée d'une minute. Ainsi lors de la mise en service de l'appareil, il s'écoule un temps suffisant pour permettre à la personne ayant enclenché l'appareil de quitter les lieux et de ne pas être considérée comme un intrus. La personne en question peut d'ailleurs encore couper la boucle 36 en agissant sur une mise hors service 38 qui renvoie alors le signal sur la boucle 30. Si le critère 38 est négatif, le signal passe dans une boucle 39 comprenant le détecteur 40. Lorsque celui-ci signale quelque chose de suspect, il envoie un signal au déclencheur 41 de l'appareil photographique puis sur un éventuel retardateur 42 pour aboutir enfin à un dispositif 43 enclenchant l'alarme acoustique.

L'appareil décrit est d'un prix relativement bas, car tous ses composants sont groupés dans un seul coffret, ce qui permet une fabrication en série, le montage et les vérifications pouvant être effectués en usine.

On peut, bien entendu, prévoir de nombreuses variantes permettant d'obtenir différents modes de fonctionnement. En particulier, l'appareil pourrait comprendre un émetteur et un récepteur pour des signaux à fréquence porteuse, ces signaux passant par les conducteurs d'alimentation électrique. Une telle disposition permet une inter-connexion entre plusieurs appareils placés dans des locaux différents d'un même immeuble. On peut ainsi obtenir que la réaction du détecteur d'un appareil mette en fonction la caméra photographique de cet appareil, avec ou sans sirène d'alarme, tandis que la sirène d'alarme d'au moins un autre appareil identique serait mise en action. L'appareil pourrait aussi comprendre des moyens, par exemple un commutateur de sélection, permettant de laisser en fonction le détecteur, ce dernier agissant sur un voyant lumineux qui, à lui seul, peut constituer un moyen de dissuasion, par exemple dans un grand magasin pour empêcher le vol à l'étalage. Ce bouton de sélection peut être placé dans des positions commandant, soit la mise en marche de la caméra seule, soit le fonctionnement de l'avertisseur acoustique seul, soit les deux ensemble.

Bien entendu, l'appareil pourrait encore être muni de connexions pour l'envoi d'un signal, par exemple enclenché manuellement, pour mettre en action le dispositif avertisseur.

## Revendications

1. Appareil de surveillance contre le vol, comprenant des moyens de détection (3) et d'alarme (8) réagissant à une présence anormale, ces moyens étant disposés à l'intérieur d'un boîtier (1) comprenant une plaque support (13) amovible munie de moyens (14) pour permettre sa fixation à une partie d'un bâtiment, caractérisé en ce que la plaque support (13) est munie de bornes électriques (19) pour raccorder l'appareil au réseau d'alimentation, ces bornes étant reliées à une partie (21) d'un connecteur fixée à la plaque support (19), l'autre partie (22) du connecteur étant reliée par des fils souples (23) à des circuits faisant partie desdits moyens de détection et d'alarme, ces moyens étant fixés dans le boîtier (1), de façon à pouvoir être enlevés avec ce dernier après séparation des deux parties (21 et 22) du connecteur.

2. Appareil selon la revendication 1, caractérisé en ce que le couvercle (13) porte encore un relais (24) dont les contacts électriques sont destinés à être reliés à un dispositif d'alarme extérieur.

3. Appareil selon la revendication 2, caractérisé en ce que le coffret (1) présente des gonds (11, 12) destinés à coopérer avec des gonds (11', 12') correspondants situés le long d'un bord du couvercle (13), le bord opposé de ce couvercle (13) présentant une partie (15) d'une serrure dont l'autre partie (16) est fixée au coffret.

4. Appareil selon l'une des revendications 1 à 3, caractérisé en ce qu'il comprend un dispositif d'horlogerie (9) à cycle hebdomadaire pour enclencher automatiquement les périodes désirées de surveillance et de non-surveillance.

5. Appareil selon l'une des revendications 1 à 4, caractérisé en ce qu'il comprend un récepteur sensible à un rayonnement et destiné à mettre l'appareil hors surveillance pendant un temps prédéterminé après réception d'un rayonnement approprié.

6. Appareil selon la revendication 5, caractérisé en ce qu'il comprend un récepteur à rayonnement infra-rouge et un accessoire extérieur pour l'émission d'un rayonnement infra-rouge codé destiné à agir sur ledit récepteur pour transmettre des informations relatives à la mise en et hors circuit du dispositif de surveillance.

7. Appareil selon l'une des revendications précédentes, caractérisé en ce qu'il comprend une caméra (5) photographique ou cinématographique et des moyens de mise en action de cette caméra par le détecteur (3).

8. Appareil selon l'une des revendications précédentes, caractérisé en ce qu'il comprend un avertisseur acoustique (8) enclenché par ledit détecteur.

9. Appareil selon la revendication 1, caractérisé en ce qu'il comprend des moyens de réception d'un signal pour mettre en action son dispositif d'alarme.

10. Appareil selon la revendication 9, caractérisé en ce qu'il comprend des moyens sensibles à une réaction du détecteur (3) et destinés à mettre en action le dispositif d'alarme d'un autre appareil.

11. Appareil selon les revendications 7 et 8, caractérisé en ce qu'il comprend un voyant lumineux dont l'intensité varie chaque fois que le détecteur réagit à une présence anormale, des moyens permettant à volonté de faire agir ou non la réaction du détecteur sur la caméra photographique et/ou sur l'avertisseur acoustique.

## Claims

1. Apparatus for monitoring against theft, comprising detection (3) and alarm (8) means that react to an abnormal presence, said means being placed inside a box (1) comprising a removable support plate (13) provided with means (14) making it possible to attach it to a part of a building, characterized in that said support plate (13) is provided with electric terminals (19) to connect the apparatus to the power supply, said terminals being connected to a part (21) of a connector attached to the support plate (19), the other part (22) of the connector being connected by flexible wires (23) to circuits forming part of said means of detection and alarm, said means being attached in the box (1) so as to be able to be removed with the latter after separation of the two parts (21 and 22) of the connector.

2. Apparatus according to Claim 1, characterized in that the cover (13) carries also a relay (24) whose electric contacts are intended to be connected to an outside alarm device.

3. Apparatus according to Claim 2, characterized in that the box (1) has hinge pins (11, 12) intended to cooperate with corresponding hinge pins (11', 12') located along an edge of the cover (13), the opposite edge of said cover (13) including a part (15) of a lock whose other part (16) is attached to the box.

4. Apparatus according to one of the Claims 1 to 3, characterized in that it comprises a timing device (9) with a weekly cycle to engage the desired periods of monitoring and non-monitoring automatically.

5. Apparatus according to one of the Claims 1 to 4, characterized in that it comprises a receiver sensitive to a radiation and intended to switch off the monitoring of the apparatus for a predetermined time after receiving an appropriate radiation.

6. Apparatus according to Claim 5, characterized in that it comprises an infrared radiation receiver and an outside accessory for emission of a coded infrared radiation intended to act on said receiver to transmit informations relating to turning the circuit of the monitoring device on and off.

7. Apparatus according to one of the preceeding Claims, characterized in that it comprises a photographic or motion picture camera (5) and means for activating this camera by the detector (3).

8. Apparatus according to one of the preceeding Claims, characterized in that it comprises en acoustic warning device (8) engaged by said detector.

9. Apparatus according to Claim 1, characterized in that it comprises receiving means for a signal in order to activate its alarm device.

10. Apparatus according to Claim 9, characterized in that it comprises means sensitive to a reaction of the detector (3) and intended to activate the alarm device of another apparatus.

11. Apparatus according to the Claims 7 and 8, characterized in that it comprises a signal light whose intensity varies each time the detector reacts to an abnormal presence, means making it possible, at will, to cause or not cause the reaction of the detector on the photographic camera and/or on the acoustic warning device.

## Patentansprüche

1. Überwachungsgerät gegen Diebstahl, umfassend Detektormittel (3) und Alarmmittel (8), die auf einen ungewöhnlichen Zustand ansprechen, wobei diese Mittel im Inneren eines Gehäuses (1) vorgesehen sind, das eine abnehmbare Trägerplatte (13) umfaßt, welche mit Mitteln (14) zu ihrer Befestigung an einem Teil eines Gebäudes versehen ist, dadurch gekennzeichnet, daß die Trägerplatte (13) mit Klemmen (19) versehen ist, um das Gerät an ein Versorgungsnetz anzuschließen, wobei diese Klemmen mit einem Teil (21) eines auf der Trägerplatte (13) befestigten Verbindungselementes verbunden sind und der andere Teil (22) des Verbindungselementes über Leitungen (23) an Stromkreise angeschlossen ist, die Teil der genannten Detektor-und Alarmmittel sind, wobei diese Mittel in dem Gehäuse (1) so befestigt sind, daß sie mit letzterem nach der Trennung der beiden Teile (21 und 22) des Verbindungs-elementes entfernt werden können.

2. Gerät nach Anspruch 1, dadurch gekennzeichnet, daß der Deckel (13) weiters ein Relais (24) aufweist, dessen elektrische Kontakte dazu vorgesehen sind, mit einer extern vorgesehenen Alarmeinrichtung verbunden zu werden.

3. Gerät nach Anspruch 2, dadurch gekennzeichnet, daß das Gehäuse (1) Beschläge (11, 12) aufweist, die dazu vorgesehen sind, mit entsprechenden Beschlägen (11', 12') zusammenzuwirken, welche längs eines Randes des Deckels (13) angeordnet sind, wobei der entgegengesetzte Rand dieses Deckels (13) einen Teil (15) eines Schlosses aufweist, dessen anderer Teil (16) an dem Gehäuse befestigt ist.

4. Gerät nach einem der Ansprüche 1 bis 3, dadurch gekennzeichnet, daß es eine Wochenzeituhr (9) umfaßt, um automatisch die gewünschten Zeiträume der Überwachung und der Nicht-Überwachung einzustellen.

5. Gerät nach einem der Ansprüche 1 bis 4, dadurch gekennzeichnet, daß es einen strahlungsempfindlichen Empfänger umfaßt, der dazu vorgesehen ist, das Gerät nach dem Empfangen einer bestimmten Strahlung für einen vorher bestimmten Zeitraum zu entschärfen.

6. Gerät nach Anspruch 5, dadurch gekennzeichnet, daß es einen Infrarotstrahlenempfänger und ein externes Zusatzgerät für die Aussendung von kodierten Infrarotstrahlen umfaßt, das dazu bestimmt ist, auf den genannten Empfänger einzuwirken, um Informationen hinsichtlich eines Ein- oder Abschaltens der Überwachungseinrichtung zu übertragen.

7. Gerät nach einem der vorhergehenden Ansprüche, dadurch gekennzeichnet, daß es eine Foto- oder Filmkamera (5) und Mittel zur Inbetriebnahme dieser Kamera durch den Detektor (3) umfaßt.

8. Gerät nach einem der vorhergehenden Ansprüche, dadurch gekennzeichnet, daß es eine von dem genannten Detektor ausgelöste akustische Meldeeinrichtung (8) umfaßt.

9. Gerät nach Anspruch 1, dadurch gekennzeichnet, daß es Empfangsmittel für ein Signal umfaßt, um seine Alarmeinrichtung in Betrieb zu setzen.

10. Gerät nach Anspruch 9, dadurch gekennzeichnet, daß es Mittel umfaßt, die auf ein Ansprechen des Detektors (3) reagieren und dazu vorgesehen sind, die Alarmeinrichtung eines anderen Gerätes in Betrieb zu setzen.

11. Gerät nach den Ansprüchen 7 und 8, dadurch gekennzeichnet, daß es eine Anzeigelampe umfaßt, deren Intensität sich jedes Mal verändert, wenn der Detektor auf einen ungewöhnlichen Zustand anspricht, wobei es Mittel ermöglichen, das Ansprechen des Detektors nach Belieben auf die Fotokamera und/oder auf die akustische Meldeeinrichtung einwirken zu lassen.

FIG. 1

FIG. 2

FIG. 3

FIG. 4